# EUROPEAN PATENT APPLICATION

(11) **EP 3 546 825 A1**
(43) Date of publication of application: **02.10.2019**
(21) Application number: 17855049.7
(22) Date of filing: 01.10.2017
(51) Int. Cl.: F21V 23/00, F21S 8/00

(54) **STRIP-SHAPED LIGHT SOURCE, MANUFACTURING METHOD THEREFOR, AND ELECTRONIC DEVICE**

(30) Priority: 30.09.2016 CN 201610878666; 21.01.2017 CN 201710044003; 21.01.2017 CN 201710044116; 23.06.2017 CN 201720745868 U
(71) Applicant: Shenzhen LT Optoelectronics Co., Ltd., Shenzhen, Guangdong 518000 (CN)
(72) Inventor: WANG, Lei, Shenzhen Guangdong 518000 (CN)
(74) Representative: Zaboliene, Reda
(86) International application number: PCT/CN2017/105196
(87) International publication number: WO 2018/059599

(57) **Abstract**

A strip-shaped light source for providing a light source for a light receiving body, the strip-shaped light source, having an elongated shape having a long-width ratio of (80-140): 1,at least two light emitting chips, a fluorescent layer, and a substrate; wherein the at least two light emitting chips are disposed on the substrate, and the fluorescent layer covers the at least two light emitting chips and a spacing region between the at least two light emitting chips, and a surface of the fluorescent layer, away from the substrate, is a main light emitting surface of the strip-shaped light source, and a ratio between an area of the main light emitting surface of the strip-shaped light source and the area of the light incident surface of the light receiving body is (0.8-1):1.

## Description

### FIELD OF THE INVENTION

The invention relates generally to the field of LED display technology, and in particular, to a strip-shaped light source, a method of manufacturing the same, and an electronic device.

### BACKGROUND OF THE INVENTION

In the display module, the backlight provides light to the display module, and the light emitted by the backlight passes through the display module to visualize the display module. Backlights are widely used in electronic devices such as mobile phones, tablets, computers, and televisions. A conventional backlight includes a light guide plate, a reflector, and a light-emitting element on one side of the light guide plate. The light emitted by the light-emitting element forms a surface light source through the light guide plate, and then reflects the light through the reflector to provide light to the display module.

Under the trend of high-definition display and thinning and thinning of electronic products, existing backlights have been difficult to meet the needs of designers. Because of the increasingly thin and light electronic products, the size of the backlight in the direction perpendicular to the display surface is required. Increasingly small and need to maintain a good light-emitting effect, reducing the size of the backlight in the direction perpendicular to the display surface, the first thing to reduce the size of the light-emitting element in the direction perpendicular to the display surface, however, the existing light It is difficult for components to meet the requirements of the designer for the size and light output of the backlight.

### SUMMARY OF THE INVENTION

In order to overcome the technical problem that the existing backlight is difficult to meet the demand for increasingly thin and light electronic products in terms of size and light-emitting effect, the present invention provides a strip-shaped light source, a manufacturing method thereof, and an electronic device.

The technical solution of the present invention is to provide a strip-shaped light source, for providing a light source for a light incident surface of a light receiving body, having an elongated shape with an length-width ratio of (80-140),has at least two light emitting chips, a fluorescent layer, and a substrate; wherein the at least two light emitting chips are disposed on the substrate, and the fluorescent layer covers the at least two light emitting chips and a spacing region between the at least two light emitting chips, and a surface of the fluorescent layer, away from the substrate, is a main light emitting surface of the strip-shaped light source, and a ratio between a area of the main light emitting surface of the strip-shaped light source and the area of the light incident surface of the light receiving body is (0.8-1):1.

Preferably, the light emitting chip is a micro-LED, the strip-shaped light source has a width of 0.5 mm or less, and the strip-shaped light source has a length of 40 mm or more.

Preferably, the strip-shaped light source has a length to width ratio of (110-130): 1: (1.2-1.6).

Preferably, the light emitting chip is a micro-LED, the strip-shaped light source comprises a plurality of micro-LEDs, and the micro-LEDs are arranged at equal intervals along a length direction of the fluorescent layer; a distance L1 between the two adjacent micro-LEDs to a distance L3 between the micro-LED to an end surface of the fluorescent layer is 1: (0.9-3.5).

Preferably, the fluorescent layer is a preformed phosphor film having a thickness of less than 0.4 mm.

Preferably, the substrate is provided with a conductive circuit, the conductive circuit comprises a plurality of first conductive units, and two ends of the light emitting chips are respectively arranged at two different first conductive units, being electrically connected to the first conductive units.

Preferably, a conductive circuit is disposed in the substrate, the conductive circuit comprises an upper conductive circuit, and the upper conductive circuit is disposed on a surface of the substrate on which the light emitting chips is disposed, the at least two light emitting chips on the surface of the substrate are electrically connected by the upper conductive circuit, and a line width of the upper conductive circuit is smaller than a width of the light emitting chip.

Preferably, the conductive circuit comprises a middle layer conductive circuit and a lower layer conductive circuit, wherein the middle layer conductive circuit is disposed in the substrate, and the lower layer conductive circuit is disposed on a surface of the substrate, the surface away from the fluorescent layer, the lower conductive circuit is connected to the upper conductive circuit through the middle layer conductive circuit.

Preferably, the strip-shaped light source comprises a PCB board, a main light emitting surface of the strip-shaped light source is perpendicular to the PCB board, and the strip-shaped light source is soldered to the PCB board for a fixed and electrical connection, through a surface away the main emitting surface.

Preferably, the strip-shaped light source comprises a PCB board, and the length and width dimensions of the PCB board are the same as the length and width dimensions of the substrate.

Preferably, the substrate is provided with a conductive circuit, the conductive circuit electrically connecting the light emitting device to at least two light emitting chipsets, and each of the light emitting chip sets comprises at least two light-emitting chips, being connected in series, at least one end of the light-emitting chip set is connected together, and the other end is independent of each other; the PCB board further includes a circuit layer, the circuit layer includes at least three power supply traces, and one of the at least three traces is the polarity of the first power source, and the other power supply traces are the polarity of the second power source, and the polarity of the first power source is opposite to the polarity of the second power source, and the light emitting chip sets are connected together, and one end is connected to the trace having the polarity of the first power source, and the other end of the light-emitting chip set is connected to a different trace having the polarity of the second power source.

Preferably, the light emitting chip is a micro-LED, and the substrate is an FPC or an insulating plate having a thermal conductivity of 5 W/(m·K) or more.

Preferably, the fluorescent layer and the substrate are perpendicular to the end faces of the main light emitting surface.

In addition, the present invention further provide a method of manufacturing a strip-shaped light source, having: providing a substrate sheet; arranging and fixing the light emitting chip array onto the substrate plate; providing a fluorescent film, wherein the fluorescent film covers the light emitting chip of the array and the substrate plate is provided with a surface of the light emitting chip to obtain a light emitting substrate, and the light-emitting substrate is cut in strips to obtain a strip-shaped light source having an elongated shape with an length-width ratio of (80-140): 1 has at least two light emitting chips, a fluorescent layer, and a substrate; wherein the at least two light emitting chips are disposed on the substrate, and the fluorescent layer covers the at least two light emitting chips and a spacing region between the at least two light emitting chips, and a surface of the fluorescent layer, away from the substrate, is a main light emitting surface of the strip-shaped light source, and a ratio between a area of the main light emitting surface of the strip-shaped light source and the area of the light incident surface of the light receiving body is (0.8-1):1.

In addition, the present invention further provide an electronic device comprising a backlight module and a display device, wherein the backlight module is configured to provide a light source to the display device, wherein the backlight module comprises the strip-shaped light source, having an elongated shape with an length-width ratio of (80-140): 1 has at least two light emitting chips, a fluorescent layer, and a substrate; wherein the at least two light emitting chips are disposed on the substrate, and the fluorescent layer covers the at least two light emitting chips and a spacing region between the at least two light emitting chips, and a surface of the fluorescent layer, away from the substrate, is a main light emitting surface of the strip-shaped light source, and a ratio between a area of the main light emitting surface of the strip-shaped light source and the area of the light incident surface of the light receiving body is (0.8-1):1.

Compared with the prior art, that is, a plurality of independently packaged light sources, because of the spacing between the independently packaged light sources, the light emitting surface and the light incident surface of the light receiving body cannot be completely matched, thereby forming a "dark area". The strip-shaped light source provided by the invention is a whole surface light emitting light, and solves the problem that the traditional light source has a "dark area" from the fundamental problem of the light source, thereby ensuring the uniformity of the light output brightness; and the strip-shaped light source has uniform light output and brightness The light efficiency and luminous flux of the strip-shaped light source can be greatly improved; specifically, the light flux of the strip-shaped light source can reach 90-100 lm, and the light efficiency is increased by 1/3-1/2.In addition, since the strip-shaped light source has good uniformity of illumination intensity in its light-emitting area, that is, there is no dark area in the edge portion, the strip-shaped light source can obtain an electronic device with a narrow border or even no border.

Since a product such as a display screen or an electronic device needs to provide a surface light source, in practice, the strip-shaped light source is located on the side of the light receiving body, and the light emitted by the strip-shaped light source is guided by the light receiving body to form a surface. light source. Even if the aspect ratio of the strip-shaped light source is as high as (80-140):1, the strip-shaped light source is very slender overall, and the ratio of the area of the main light emitting surface to the light incident surface area of the light receptor is (0.8-1): In the case of 1, the strip-shaped light source can meet the requirements of products such as thin and light display screens or electronic devices, and at the same time can satisfy the light-emitting effect. Further preferably, the strip-shaped light source has a length to width ratio of (110-130):1:(1.2-1.6), which can meet the size requirement and light-out requirement of a thinner and lighter display screen or electronic device, and is more suitable for no-border. The development trend of electronic equipment.

The light emitting chip is a micro-LED, the width of the strip-shaped light source is less than or equal to 0.5 mm, and the length of the strip-shaped light source is greater than or equal to 40 mm, which can reduce at least 10% of the thickness of the existing electronic products, especially consumer electronic products (such as mobile phones). , the possibility of implementation of the thin and light design of existing mobile phone manufacturers.

In order to further ensure the display effect of the edge region of the product such as the display screen or the electronic device, the length of the light-emitting chip is 11, and the distance between the light-emitting chip at the two ends and the end surface of the fluorescent layer is 13, and the range of 11:13 is 1: (0.9-3.5).Further preferably, the ratio of the length 11 of the light-emitting chip to the distance 12 of the light-emitting chip is 1: (1.8-2.2).Under the condition of the parameter, the display effect of the edge area of the display or electronic device is basically the same as that of the central area of the display, and the uniformity of the light output of the strip-shaped light source is the best.

As a fluorescent layer, the prefabricated fluorescent film has excellent controllability and consistency, and the thickness can be less than 0.4 mm and the color chromaticity can still be guaranteed. It can meet the needs of products such as display screens or electronic devices without borders or narrow borders.

Both ends of the light-emitting chip are disposed on the first conductive unit, so that the electrical connection of the light-emitting chip can be realized without using a gold wire. Further preferably, the line width of the first conductive unit is smaller than the width of the light-emitting chip, which enables the manufacture of a narrower strip-shaped light source to meet the needs of thinner and lighter electronic devices.

The circuit board and the substrate are soldered to the circuit board on the side of the substrate away from the main light emitting surface to realize a fixed connection and an electrical connection. The arrangement structure makes the strip-shaped light source compact and the connection between the circuit board and the substrate is stable.

The length and width of the circuit board are the same as the length and width of the substrate. The circuit board is directly disposed on the substrate side and integrated with the substrate. The overall thickness is thin and light, and the installation is convenient, and is very suitable for use in an electronic device without a frame.

When the substrate is made of FPC material, the overall thickness of the strip-shaped light source is reduced to 50% or less of the conventional product, and the strip-shaped light source is reduced in weight, size, and thickness. Further, since the light emitting chip is not limited by the material of the substrate, the strip-shaped light source prepared by the method has better wrap ability, and the strip-shaped light source can be particularly suitable for thin and thin frameless electronic devices. Or in an electronic device with a flexible screen.

The invention also provides a method for manufacturing a strip-shaped light source, which makes it possible to mass-produce the strip-shaped light source. Even in the case where the strip-shaped light source is very small in size and the aspect ratio is very large, smooth mass production of the strip-shaped light source can be ensured. The preparation method of the strip-shaped light source is simple and easy to operate, and the production efficiency is remarkably improved, and the problem of single dispensing and low work efficiency in the independent light emitting chip package can be avoided in the existing method. Moreover, it is possible to prepare strip-shaped light sources of different sizes according to the needs of practical applications. Finally, the strip-shaped light source has the advantages of no dark area and uniform illumination. Further prefabricating the fluorescent film is achieved by a hot pressing process with a temperature difference exceeding 30 ° C to achieve fixation on the surface of the substrate sheet. The process and the material of the fluorescent film make the fixing between the fluorescent film and the surface of the substrate sheet relatively stable. The fixing strength is more than three times higher than the fixing strength between the substrate and the fluorescent layer in the conventional backlight. Therefore, even in a strip-shaped light source having a large aspect ratio, the fluorescent layer can be stably fixed on the substrate, and is not easily peeled off even during long-term use, thereby ensuring the quality of the strip-shaped light source.

The invention also provides an electronic device, which has good display effect, can be made very thin in thickness, and can effectively reduce the frame width of the display device in the electronic device, and even achieve the effect of no border.

### BRIEF DESCRIPTION OF THE DRAWINGS

FIG.1 is a perspective view showing the structure of a strip-shaped light source of the first embodiment according to the present invention.
FIG.2 is a bottom plan view showing a light-emitting substrate in the first embodiment of the present invention.
FIG.3 is a schematic enlarged view of showing a structure of part A of Figure 2.
FIG.4 is a structure schematic view showing the strip-shaped light source and a light receiving body of the first embodiment according to the present invention.
FIG.5 is a front view showing a light-emitting substrate of the first embodiment according to the present invention.
FIG.6 is a schematic partial cross-sectional view along a profile B-B of Figure 5.
FIG.7 is a schematic enlarged view showing a structure of part C in Figure 6.
FIG.8 is a bottom view showing a portion of the light-emitting substrate in the first embodiment of the present invention.
FIG.9 is a schematic structural view of an LED light bar of the prior art.
FIG.10 is a schematic diagram showing a circuit connection of a first conductive unit and light emitting chips of the first embodiment according to the present invention.
FIG.11 is a schematic view showing a circuit connection of a conductive circuit and the light-emitting chips of the first embodiment according to the present invention.
FIG. 12A is a schematic view showing a layer structure according to the first embodiment of the present invention, which has a white coating layer, a first insulating layer, a wiring layer, and a second insulating layer.
FIG.12B is a circuit diagram showing a wiring layer of a PCB board of the first embodiment according to the present invention.
FIG.12C is a schematic view showing a structure of the first insulating layer of the PCB board of the first embodiment according to the present invention.
FIG.12D is a schematic view showing a structure of the white coating of the PCB board of the first embodiment according to the present invention.
FIG.13 is a schematic view showing an light-emitting effect of the strip-shaped light source of the first embodiment according to the present invention.
FIG.14A, FIG.14B and FIG.14C are schematic views respectively showing three deformation structures of the strip-shaped light source of the first embodiment according to the present invention.
FIG.15A is a cross-sectional structural view of a backlight module of a second embodiment according to the present invention.
FIG.15B is a schematic assembly view showing an assembly of a backlight module of the second embodiment according to the present invention, which has a backlight frame and a strip-shaped light source of.
FIG.15C is a partially enlarged schematic view showing a cross-sectional structure of the backlight module of the second embodiment according to the present invention.

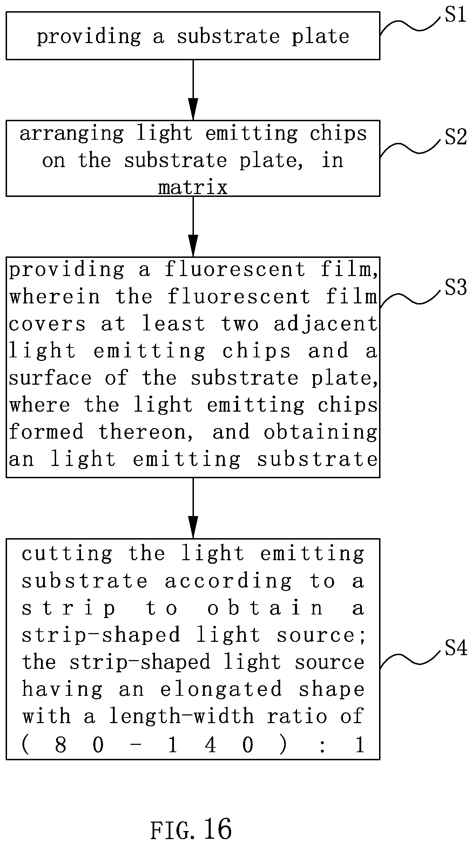

FIG.16 is a flow chart showing a manufacturing method of the strip-shaped light source of a fourth embodiment according to the present invention.

### DETAILED DESCRIPTION OF THE INVENTION

The invention will be described with reference to the accompanying drawings and the specifications. These and/or other aspects and advantages of the invention will become apparent and more readily appreciated from the following description of the embodiments, taken in conjunction with the accompanying drawings.

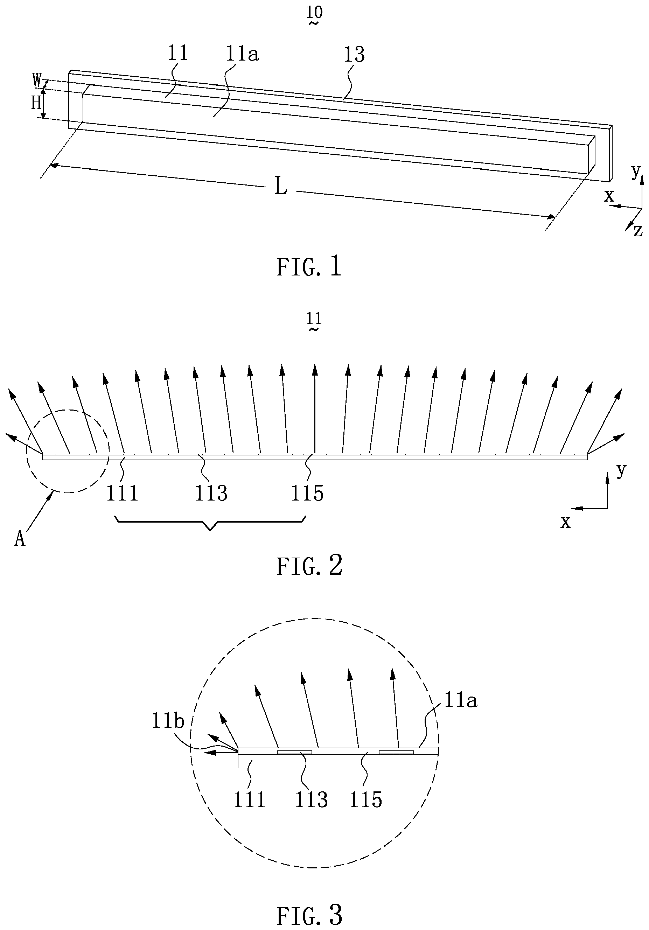

Referring to FIG. 1, a first embodiment of the present invention provides a strip-shaped light source 10, which includes a light emitting substrate 11 and a circuit board 13. The light emitting substrate 11 is illuminated after being energized, and the upper surface of the light emitting substrate 11 is Main light exit surface 11a.The PCB board 13 is electrically connected to the light-emitting substrate 11 for supplying power to the light-emitting substrate 11.The plane of the PCB board 13 is preferably disposed perpendicular to the main light-emitting surface 11a of the light-emitting substrate 11, that is, the PCB board 13 is disposed on the back surface of the light-emitting substrate 11.Preferably, the circuit board 13 is a rigid circuit board or a flexible circuit board. Preferably, the light-emitting substrate 11 has an elongated shape, and is more preferably a rectangular parallelepiped. In the present embodiment, the light-emitting substrate 11 is a rectangular parallelepiped as an example. The light-emitting substrate 11 is set to have a length L, a width W, a height H, an aspect ratio of (40-140): 1, preferably an aspect ratio of (80-140): 1, and further preferably an aspect ratio (110-130): 1.Preferably, the aspect ratio is: (80-140): 1: (0.8-2.5), further preferably (110-130): 1: (1.2-1.6).The circuit board 13 can be omitted, and the light-emitting substrate 11 is a strip-shaped light source 10, and the light-emitting substrate 11 is directly connected to a power supply.

Preferably, the length of the strip-shaped light source 10 is greater than or equal to 40 mm, and specifically may be 50 mm, 55 mm, 68 mm, 72 mm, 75 mm or 80 mm. The width is preferably less than 2 mm, in particular, may be less than 1 mm or 0.5 mm.

Referring to FIG. 2 together, the light-emitting substrate 11 includes at least two light-emitting chips 113, a fluorescent layer 115, and a substrate 111.The light emitting chip 113 is disposed on the substrate 111, and the fluorescent layer 115 covers at least two light emitting chips 113 and the substrate 111 is provided with a surface of the light emitting chip 113, that is, the fluorescent layer 115 covers at least two light emitting chips. 113 and a spacer region between the LED chips, the substrate 111 provides a base carrier for the fluorescent layer 115 and the light emitting chip 113.The light emitted by the light-emitting chip 113 is converted by the fluorescent layer 115 to emit light as a whole. Referring to FIG. 3 together, the surface of the fluorescent layer 115 away from the substrate 111 is the main light emitting surface 11a of the light emitting element 1. It can be understood that the side light emitting surface 11b is formed on the side surface thereof. That is, the light emitted from the main light-emitting surface 11a is emitted in the y-axis direction in the drawing.

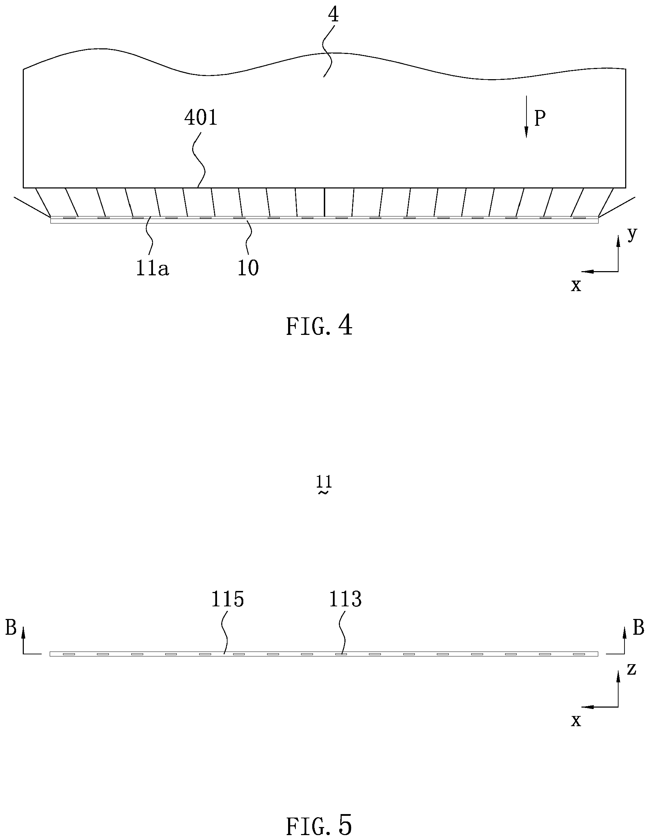

Referring to FIG. 4 together, the strip-shaped light source 10 is used to provide a light source for the light incident surface 401 of a light receiving body 4, such as urban lighting and industrial lighting, and is particularly suitable for use as a backlight on a display of an electronic product. The ratio between the area of the main light-emitting surface 11a of the strip-shaped light source 10 and the area of the light-receiving surface 401 of the light-receiving body 4 is (0.8-1):1.And with the strip-shaped light source 10 of the present invention, the ratio is preferably up to 1:1.Generally, when the strip-shaped light source 10 is used in a side-side backlight module, the main light-emitting surface 11a of the strip-shaped light source 10 is in contact with the light-receiving surface 401 of the light-receiving body 4.In FIG. 4, the main light emitting surface 11a of the strip-shaped light source 10 and the light incident surface 401 of the light receiving body 4 are clearly shown, that is, in actual arrangement, the light receiving body 4 moves in the direction indicated by the arrow P, The main light emitting surface 11a of the strip-shaped light source 10 is brought into contact with the light incident surface 401 of the light receiving body 4.That is, the main light emitting surface 11a of the strip-shaped light source 10 corresponds to the light incident surface 401 of the light receiving body 4, so that the area of the main light emitting surface 11a of the strip-shaped light source 10 and the light receiving body 4 are lighted as described above. The ratio between the areas of the faces 401 is (0.8-1): 1, which is understood to be that when the main light-emitting surface 11a of the strip-shaped light source 10 corresponds to the light-receiving surface 401 of the light-receiving body 4, the light-emitting The area of the main light-emitting surface 101 of the element 1 may occupy 80-100% of the area of the light-incident surface 401 of the light-receiving body 4.It should be noted that, in actual application, an error occurs in the manufacturing process, and therefore, within an error range of 10%, that is, the area of the main light-emitting surface 11a of the strip-shaped light source 10 and the area of the light-receiving surface 401 of the light-receiving body 4 When the ratio between them is in the range of (0.72-1.1): 1, it should also be within the scope of protection of the present invention.

Compared with the prior art, that is, a plurality of independently packaged light sources, because of the spacing between the independently packaged light sources, the light emitting surface and the light incident surface of the light receiving body 4 cannot be completely matched, thereby forming a "dark area". The strip-shaped light source 10 provided by the present invention is a full-surface light emitting light, and solves the problem that the conventional light source has a "dark area" from the fundamental problem of the light source, thereby ensuring the uniformity of the light output brightness; and the strip-shaped light source 10 emits light uniformly. The brightness and the luminous flux of the strip-shaped light source 10 can be greatly improved; specifically, the luminous flux of the strip-shaped light source 10 can reach 90-100 lm, and the luminous efficiency is increased by 1/3-1/2.In addition, since the strip-shaped light source 10 has good uniformity of illumination intensity in its light-emitting area, that is, there is no dark area in the edge portion, the strip-shaped light source 10 can be used to obtain a narrow frame or even a frameless electronic device.

Since a product such as a display screen or an electronic device is required to provide a surface light source, the strip-shaped light source 10 is located on the side of the light receiving body 4 in practical use, and the light emitted by the strip-shaped light source 10 is guided by the light receiving body 4. After that to form a surface light source. Even if the aspect ratio of the strip-shaped light source 10 is as high as (80-140):1, the ratio of the area of the main light-emitting surface of the strip-shaped light source 10 to the light-incident surface area of the light-receiving body is (0.8-1):1. The strip-shaped light source 10 can meet the requirements of products such as thin and light display screens or electronic devices, and at the same time can satisfy the light-emitting effect.

Preferably, the ratio between the length of the strip-shaped light source 10 and the length of the strip-shaped light source 10 on the side of the light receiving body 4 is 1: (1-1.2).Within this ratio range, it is ensured that a surface light source having uniform luminous intensity can be obtained. Further, the ratio between the length of the strip-shaped light source 10 and the length of the strip-shaped light source 10 on the side of the light receiving body 4 is 1:1.1.Further, it is more preferable that the main light-emitting surface 11a of the strip-shaped light source 10 is in contact with the light-incident surface 401 of the light-receiving body 4.

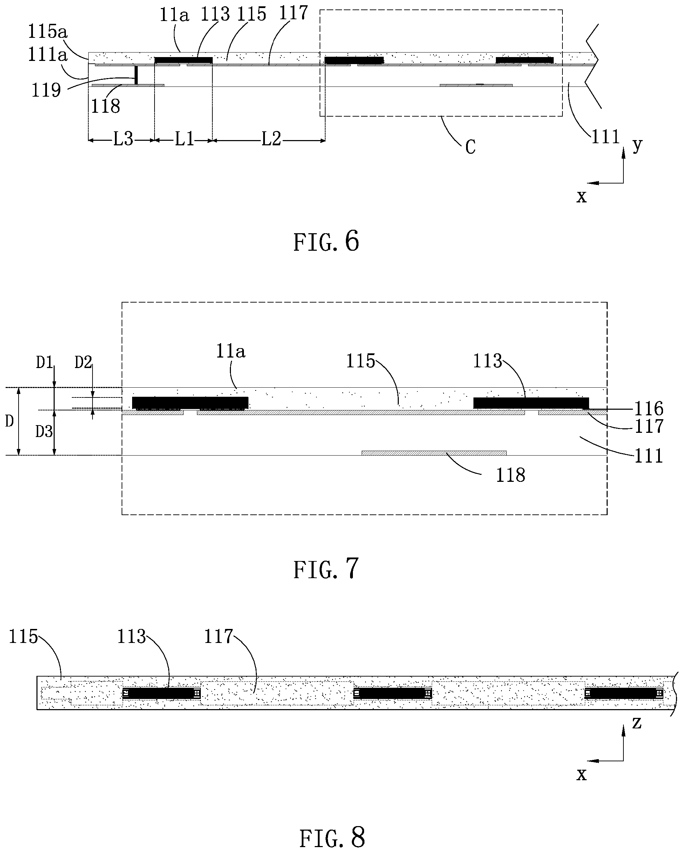

Referring to FIG. 5 and FIG. 6 together, at least two light-emitting chips 113 are arranged at equal intervals and in a straight line along the longitudinal direction of the light-emitting substrate 11 on the upper surface of the substrate 111.In this embodiment, 16 light-emitting chips 113 (d1-d16) are taken as an example for illustration. The size of the single light-emitting chip 113 in the longitudinal direction of the light-emitting substrate 11 is 11, and the pitch of the adjacent two light-emitting chips 113 is 12, preferably 11:12 is 1: (0.6-2), and the light of the strip-shaped light source 10 is ensured. effect. Further preferably, 11:12 is 1:(1.5-2.5), and further 11:12 is 1:(1.8-2.2).

The opposite end faces of the light-emitting substrate 11 are referred to as a first end and a second end, and the distance between the light-emitting chip 113 closest to the first end and the first end is 13, and the light-emitting chip 113 closest to the second end is The second end distance is also 13, preferably 11: 13 is 1: (0.9-3.5), further, 11: 13 is 1: (1.1-3.5), and further 11: 13 is 1: (1.5- 3.5).By determining the range, an arrangement of the preferred light-emitting chips 113 is obtained, and the light-emitting effect of the strip-shaped light source 10 is ensured. In other embodiments, the spacing between adjacent two of the light emitting chips 113 is different.

The light emitting chip 113 is a micro-LED. Specifically, whether the plurality of the light emitting chips 113 are equally arranged or not, the length L1 of the light emitting chip 113 is preferably 0.8-1.6 mm, and the specific values are 0.8 mm, 0.9 mm, and 1 mm. , 1.1 mm, 1.2 mm, 1.3 mm, 1.4 mm, 1.5 mm or 1.6 mm; the distance between the end faces of the light-emitting chip 113 and the fluorescent layer 115 is L3, that is, the light-emitting chip 113 and the fluorescent layer 115 at both ends The distance L3 between the end faces perpendicular to the longitudinal direction thereof is 0.5-2.5 mm, and the specific values are 0.5 mm, 0.6 mm, 0.7 mm, 0.8 mm, 0.9 mm, 1 mm, 1.1 mm, 1.2 mm, 1.3 mm, 1.4mm, 1.5mm, 1.6mm, 1.7mm, 1.8mm, 1.9mm, 2mm, 2.1mm, 2.2mm, 2.3mm, 2.4mm or 2.5mm; this avoids the luminous intensity at the edge of the illuminating area and the central area The luminous intensity is inconsistent, and the uniformity of the luminous intensity of the entire light-emitting area is improved. Further, when a plurality of the light emitting chips 113 are equally spaced, the distance L2 between two adjacent light emitting chips 113 is 1.5-3.5 mm, and the specific values may be 1.5 mm, 1.6 mm, 1.7 mm, and 1.8. Mm, 1.9mm, 2mm, 2.1mm, 2.2mm, 2.3mm, 2.4mm, 2.5mm, 2.6mm, 2.7mm, 2.8mm, 2.9mm, 3mm, 3.1mm, 3.2mm, 3.3mm, 3.4mm or 3.5mm In this way, while ensuring the luminous intensity and the light effect of the strip-shaped light source 10, the number of the light emitting chips 113 in the strip-shaped light source 10 of the same length is reduced, and the cost is reduced.

Each of the light emitting chips 113 includes two positive and negative electrical terminals. In the present invention, the light-emitting chip 113 is preferably a blue-light LED chip. As a variant, it may also be a red light LED chip, a green light LED chip or a yellow light LED chip or an orange light LED chip or the like.

The substrate 111 is a strip of rigid or flexible sheet material, preferably a rigid sheet material.Specific materials can be ceramics, polyethylene terephthalate (PET), PI (polyimide), PC (polycarbonate), polyester (PE), polyetheretherketone (PEEK), polyether A composite of any two of imide (PEI), polyethylene (PE), polytetrafluoroethylene (PTFE) or polyvinyl chloride (PVC).Preferably, the shape of the substrate 111 is a rectangular parallelepiped. Preferably, the substrate 111 is made of an insulating sheet having a thermal conductivity of 5 W/(m•K) or more.

As another preferred embodiment, the substrate 111 is a flexible circuit board (FPC), since the flexible circuit board itself has a conductive circuit, that is, the flexible circuit board includes a conductive circuit of the strip-shaped light source 10.The shape of the conductive circuit can be adjusted as needed. The structural arrangement in which the light-emitting chip 113 is directly disposed on the FPC in this embodiment can reduce the overall thickness of the strip-shaped light source 10 to less than 50% of the existing product. In addition, since the flexible circuit board has the characteristics of being freely bendable, folded, and wound, and can be freely moved in a three-dimensional space, the light-emitting chip 113 is directly disposed on the flexible circuit board 12, which can be realized. The strip-shaped light source 10 is made lightweight, miniaturized, and thinned. The FPC includes two insulating films and a circuit disposed between the two insulating films. The circuit is similar to the structure in the circuit board, and the circuit is exposed by opening holes in one of the insulating layers to facilitate electrical connection with the light emitting chip..

Referring to FIG. 6, FIG. 7 and FIG. 8, the fluorescent layer 115 is disposed on the surface of the substrate 111 where the light emitting chip 113 is located and completely covers the surface and the light emitting chip 113.It can be understood that the fluorescent layer 115 is covered with at least two gaps between the light emitting chip 113 located on the surface of the substrate 111 and the light emitting chip 113.Preferably, at least two end faces 115a (refer to FIG. 6) of the fluorescent layer 115 are coplanar with at least two end faces 111a of the substrate 111, and an end face 115a of the fluorescent layer 115 and an end face 111a of the substrate 111 both intersect the main light exit face 11a. In the present embodiment, the four end faces 115a of the fluorescent layer 115 are coplanar with the four end faces 111a of the substrate 111, and the end faces of the fluorescent layer 115 and the substrate 111 are the end faces of the light-emitting substrate 11.The four end faces 115a of the fluorescent layer 115 together with the four end faces 111a of the substrate 111 and the main light exiting face 11a define the outer contour of the light emitting substrate 11.

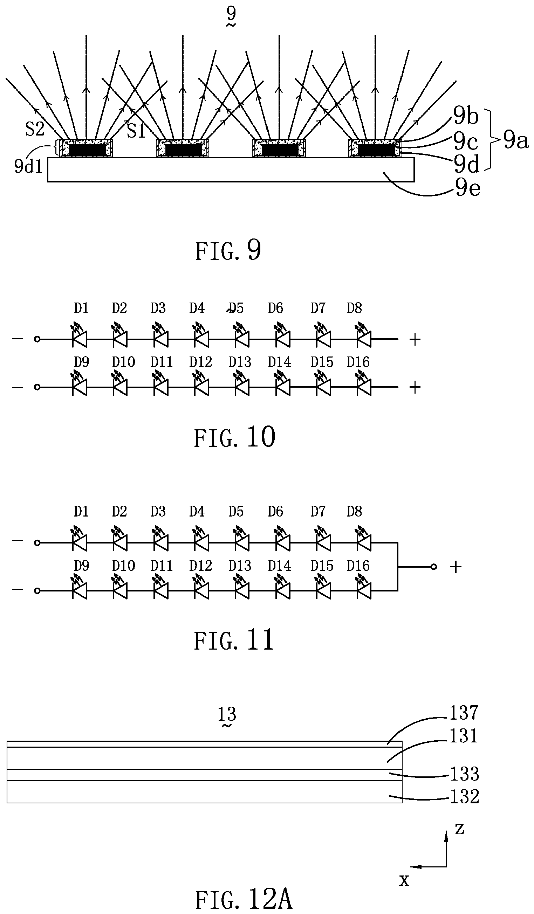

As shown in FIG. 9, the conventional LED light bar 9 includes a substrate 9e on which a plurality of LED light sources 9a are fixed. The LED light source 9a includes an LED chip 9c, a fluorescent layer 9b, and a base 9d. The upper surface of the base 9d (The orientation words mentioned in the present invention are the relative positions of the specified views, not the absolute positions. It can be understood that after the specified view is rotated 180 degrees in the plane, the position word "up" should become "lower", " The left side is turned into a "right" or the like) recessed inwardly so that the base 9d has a "concave" shape in cross section, the recessed area forms a receiving space, the LED chip 9c is disposed at the bottom of the receiving space, and a fence structure is formed on the upper portion of the base 9d. 9d1.The fluorescent layer 9b covers the LED chip 9c, and the upper surface of the fluorescent layer 9b is flush with the upper surface of the fence structure 9d1. It can be understood that the fence structure 9d1 is disposed around the LED chip 9c and the fluorescent layer 9b.The upper surface of the fluorescent layer 9b together with the upper surface of the fence structure 9d1 constitutes the upper surface of the LED light source 9a.

The fence structure 9d1 defines the boundary of the fluorescent layer 9b. When the fluorescent layer 9b is formed on the substrate 9e by using a fluorescent glue, since the fluorescent glue is in a fluid state, it has fluidity. Therefore, it is necessary to provide the fence structure 9d1 to define the fluorescent glue. Flow area. However, the arrangement of the fence structure 9d1 leads to a certain degree of complexity and cost improvement of the LED light source 9a process.

When the LED chip 9c is turned on, the light emitted from the LED chip 9c is mixed by the fluorescent layer 9b and then emitted. Since the presence of the fence structure 9d1 blocks a part of the light emitted from the left end surface and the right end surface of the fluorescent layer 9b, there is a dark light or a low light intensity between the adjacent LED light sources 9a and the side of the LED light source 9a. The area, as indicated by S1, is located between the adjacent two LED light sources 9a, as indicated by S2, at the side of the LED light source 9a at the extreme end of the LED strip 9.The existence of the dark area makes the light intensity distribution in the illumination area of the LED light source uneven, whether it is applied to the display of the electronic product or the urban illumination or the industrial illumination, and the user experience is poor.

However, the light-emitting substrate 11 provided in this embodiment has no fence structure in the existing LED light bar, so the process of the corresponding strip-shaped light source 10 is simplified and the cost is reduced. Further preferably, the entire shape of the fluorescent layer 115 perpendicular to the four end faces of the main light-emitting surface 11a and the main light-emitting surface 11a is a rectangular parallelepiped shape. As a variant, the fluorescent layer 115 is formed perpendicular to the four end faces of the main light-emitting surface 11a to form a rectangular trapezoidal body, a truncated cone or the like.

As shown in FIG. 7, the thickness of the fluorescent layer 115 is d1, the thickness of the light emitting chip 113 is d2, the thickness of the substrate 111 is d3, and the thickness of the light emitting substrate 11 is d, When there is no circuit board 13, the thickness of the strip-shaped light source 10 is also d, and d = d1 + d3.Preferably, the range of d1:d2 is (1.2-3):1, and the ratio range is too small, the luminous effect of the strip-shaped light source 10 is poor, taking the blue LED chip and the yellow fluorescent layer as an example, when the ratio range is too In an hour, the blue light emitted by the blue LED chip cannot be completely converted into white light through the yellow phosphor layer, so that the light emitted by the strip-shaped light source 10 may leak blue light. When the ratio range is too large, the thickness of the strip-shaped light source 10 is directly increased, thereby directly affecting the thickness of the backlight module or the electronic device having the strip-shaped light source 10, which cannot meet the needs of the existing market. Therefore, the preferred ratio range ensures both the illuminating effect of the strip-shaped light source 10 and the thickness of the strip-shaped light source 10 within a small range.

In order to further improve the light-emitting effect and stability of the strip-shaped light source 10, it is preferable that the range of d3:d1 is (1-3):1.

Specifically, in some preferred embodiments, the thickness D of the strip-shaped light source 10 is 0.3-1.5 mm, that is, the specific value of the thickness D of the strip-shaped light source 10 is 0.3 mm, 0.4 mm, 0.5 mm, 0.6. Mm, 0.7 mm, 0.8 mm, 0.9 mm, 1 mm, 1.1 mm, 1.2 mm, 1.3 mm, 1.4 mm or 1.5 mm. Or, in other preferred embodiments, the thickness D1 of the fluorescent layer 115 is larger than the thickness D2 of the light emitting chip 113 by 0.05-0.2 mm, and the specific values may be 0.05 mm, 0.08 mm, 0.1 mm, and 0.12 mm. , 0.14mm, 0.15mm, 0.18mm or 0.2mm.Or, in other preferred embodiments, the thickness D1 of the fluorescent layer 115 is 0.15-1 mm, that is, the thickness D1 of the fluorescent layer 115 may specifically be 0.15 mm, 0.2 mm, 0.25 mm, 0.3 mm, 0.35. Mm, 0.4 mm, 0.45 mm, 0.5 mm, 0.55 mm, 0.6 mm, 0.65 mm, 0.7 mm, 0.75 mm, 0.8 mm, 0.85 mm, 0.9 mm, 0.95 mm or 1 mm, and further, the substrate 111 The thickness D3 is 0.1-1.2 mm, that is, the thickness D3 of the substrate 111 may specifically be 0.1 mm, 0.2 mm, 0.3 mm, 0.4 mm, 0.5 mm, 0.6 mm, 0.7 mm, 0.8 mm, 0.9 mm, 1 mm, 1.1mm or 1.2mm.By optimizing these specific dimensions, the luminous effect and stability of the strip-shaped light source 10 can be further improved.

The fluorescent layer 115 is preferably a pre-formed fluorescent film made by mixing a phosphor with a colloid. The pre-fabricated film is a film which is fixed to the surface of the substrate 111 on which the light-emitting chip 113 is located by heat pressing or vacuum adsorption or the like. The phosphor is uniformly distributed in the fluorescent layer 115.Alternatively, the fluorescent layer 115 may be a phosphor mixed with a colloid and then covered on the surface of the substrate 111 where the chip 113 is located by a dispensing process. Preferably, the phosphor has a mass of 30% to 50% of the total mass of the phosphor and the silica gel. The fluorescent layer 115 is preferably a pre-formed fluorescent film prepared by mixing a phosphor and a colloid. The mixed phosphor is a mixture of a red phosphor, a green phosphor and a yellow phosphor, and preferably has a mass ratio of (1∼4): (0.5∼2): (0.5∼2) red phosphor, green Light phosphor and yellow phosphor. Preferably, the red phosphor is potassium fluorosilicate and the yellow phosphor is yttrium aluminum garnet. The mass ratio of the mixed phosphor is further (1∼3): (0.5∼1.5): (0.5∼1.5). Most preferably 2: (0.8-1): (0.8-1).Preferably, the green phosphor is a mixture of one or more of a halosilicate, a sulfide, a silicate, and an oxynitride. The green phosphor may further be a sialon green phosphor. Preferably, the red phosphor, the green phosphor and the yellow phosphor have an average particle diameter of 5 um to 30 um. The colloid is preferably silica gel. It can be understood that the phosphor may also be uniformly mixed with one or more of a red phosphor, a green phosphor, and a yellow phosphor.

The light-emitting substrate 11 further includes a conductive circuit (not labeled), and the conductive circuit is disposed on the surface or inside of the substrate 111 for connecting the light-emitting chip 113 and the circuit board 13.The conductive circuit includes a plurality of first conductive units 117, conductive lines 119, and at least two second conductive units 118 for electrically connecting the first conductive unit 117 and the second conductive unit 118.The plurality of first conductive units 117 are arranged on the upper surface of the substrate 111 at equal intervals in a line to form an upper conductive circuit, and the plurality of second conductive units 118 are arranged on the lower surface of the substrate 111 at equal intervals in a line to form a lower conductive circuit. The positive and negative electrodes of the same light-emitting chip 113 are electrically connected to the adjacent two first conductive units 117 by solder 116, respectively, and the light-emitting chips 113 are fixed to the upper surface of the substrate 111 by the solder 116.That is, the solder 116 is electrically connected to the positive electrode of the light emitting chip 113 and the first conductive unit 117, and the negative electrode of the light emitting chip 113 and the other first conductive unit 117.The first conductive unit 117 electrically connects the plurality of light-emitting chips 113 into two or more light-emitting chip sets, and each light-emitting chip set includes at least two light-emitting chips 113 connected in series. As shown in FIG. 10, the light-emitting chip in this embodiment The number of groups is two, and each of the light-emitting chipsets includes eight light-emitting chips 113 connected in series. The solder 116 may be solder paste, solder, conductive paste, silver paste or copper. The conductive wire 119 is not limited to a linear shape, and may be a block shape, a spherical shape or other irregular shape.

The number of the second conductive units 118 is preferably a plurality. In the present invention, the second conductive unit 118 is taken as an example for illustration. The six second conductive units 118 include one positive conductive unit, two negative conductive units, three sub-conductive units, and the six conductive units. 118 from left to right, the positive conductive unit, the negative conductive unit, the sub-conducting unit, the sub-conducting unit, the sub-conducting unit and the negative conducting unit are arranged in a straight line, and the positive poles of the two light-emitting chip sets are electrically connected to the positive conducting unit, and the connection thereof is The method may be that the positive electrodes of the two light-emitting chip sets are respectively connected to the positive conductive unit through different conductive lines 119, or the positive electrodes of the two light-emitting chip sets are connected together and connected to the positive conductive unit through a conductive line 119.The negative electrodes of the two light-emitting chipsets are respectively connected to the two negative conductive units through different conductive lines 119.As shown in FIG. 11, the positive electrodes of the two light-emitting chip sets are connected together; the negative electrodes of the two light-emitting chip sets are independent of each other, that is, not connected together, and the negative electrodes will be independently connected to different power supply lines. The three sub-conducting units may be selected to be connected to the negative electrode or the positive electrode of the light-emitting chip set, or may be selected not to be connected. Preferably, the three sub-conducting units provide a mechanical connection between the strip-shaped light source 10 and other components.

The conductive line 119 forms a middle layer conductive circuit which is preferably formed by disposing a through hole in the substrate 111 and placing a conductive material in the through hole. It can be understood that the conductive material may also be embedded in the substrate 111 by integral molding or the like.

The first conductive unit 117 may be sprayed with a white shielding layer to protect the first conductive unit 117 except for the portion in contact with the solder 116, or a reflective layer may be disposed on the upper surface of the substrate 111 to enhance the light reflection effect to enhance light utilization. rate. In the present invention, the white shielding layer or the reflective layer is omitted.

Referring to FIG. 12a, the circuit board 13 has an overall "1" shape, and the length of the long side of the "1" shape is greater than or equal to the length of the light-emitting substrate 11.The circuit board 13 includes, in order from top to bottom, a white coating layer 137, a first insulating layer 131, a second insulating layer 132, and a wiring layer 133. The first insulating layer 131 and the second insulating layer 132 are disposed and will be placed together. A line layer 133 is fixed between the two.

Preferably, the length and width dimensions of the PCB board 13 are the same as the length and width dimensions of the substrate 111. The PCB board 13 may be disposed on a surface of the substrate 111 away from the fluorescent layer 115, so that the strip-shaped light source 10 as a whole has a rectangular parallelepiped shape. It can be installed in other products very lightly and easily.

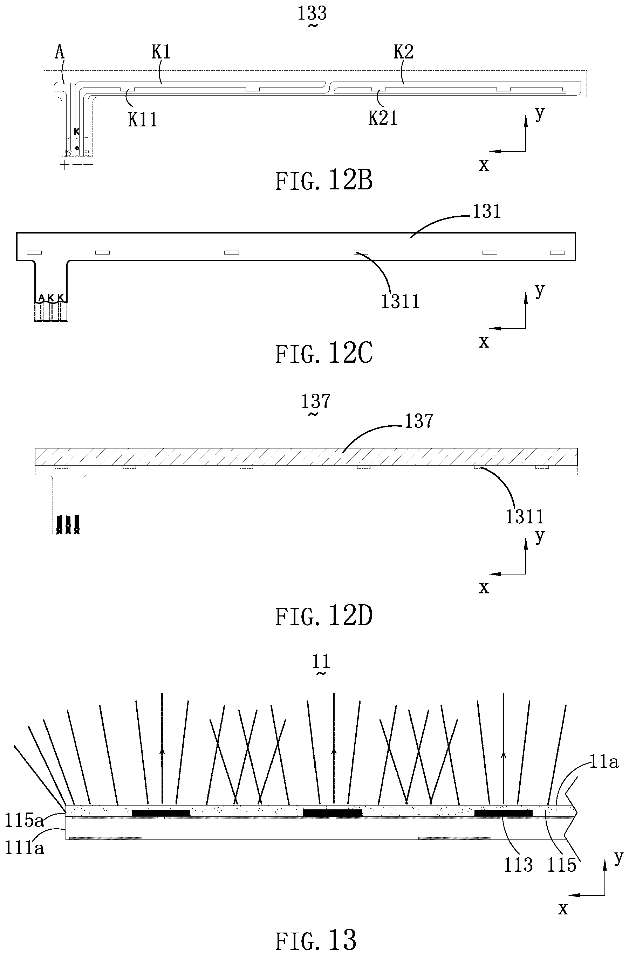

Referring to FIG. 12B, the trace layer 133 has an overall "1" shape, and includes a first trace a for conduction, a second trace k1 and a third trace k2, and a second trace k1 and a third trace. K2 is connected to the negative pole of the power supply, and the first trace a is connected to the positive pole of the power supply. The first trace a, the second trace k1 and the third trace k2 are electrically insulated from each other. Two electrical connection blocks k11 are disposed on the second trace k1, and two electrical connection blocks k21 are disposed on the third trace k2. It can be understood that the electrical connection block k11 and/or the electrical connection blocks k11, k12 may be one or more, and the position thereof is not limited, and is preferably raised on the side of the second trace k1 and the third trace k2 and is in a straight line. arrangement. The first trace a, the second trace k1 and the third trace k2 are arranged to keep at least a part of the three on the same straight line. The electrical connection blocks k11, k12 can be omitted.

Referring to FIG. 12C, the first insulating layer 131 is made of a sheet-like insulating material. The surface of the first insulating layer 131 is provided with at least a plurality of through holes 1311 arranged in a line, and the position and number of the through holes 1311 are distributed to the substrate. The distribution positions and the number of the second conductive units 118 on the bottom surface of the 111 are in one-to-one correspondence. The through hole 1311 causes the first trace a, the second trace k1 and the third trace k2 located between the first insulating layer 131 and the second insulating layer 132 to be partially exposed at the through hole 1311.Preferably, the position of the through hole 1311 is in one-to-one correspondence with the positions of the electrical connection blocks k11 and k12. In this embodiment, specifically, the first trace a portion, the second electrical connection block k11 on the second trace k1, and the third trace The other of the two electrical connection blocks k21 and the third trace k2 of k2 are exposed at the plurality of through holes 1311.The second conductive unit 117 on the surface of the substrate 111 opposite to the surface of the substrate 111 where the fluorescent layer 113 is located is connected to the first trace a exposed at the through hole 1311 by solder joints, the second trace k1 and the third trace k2 The solder joint is an electrical connection point of the conductive circuit of the light-emitting substrate 11 with the circuit board 13.It can be understood that the side of the substrate 111 away from the fluorescent layer 115 is soldered on the PCB board 13.The positive conductive unit is electrically connected to the first trace a exposed at the through hole 1311, wherein one negative conductive unit and one sub-conductive unit are respectively connected with the two electrical connection blocks k11 of the second trace k1 exposed at the through hole 1311. The other negative conductive unit is electrically connected to the third trace k2 exposed at the through hole 1311.The remaining two sub-conducting units are respectively connected to the two electrical connection blocks k21 of the third trace k2 exposed at the through hole 1311, that is, the positive electrodes of the two light-emitting chip sets are electrically connected to the first trace a, two groups The cathodes of the light-emitting chips 113 are electrically connected to the second trace k1 and the third trace k2, respectively.

As a variant, the number of the light-emitting chips 113 is not limited. The number of electrically conductive circuits electrically connected to the number of light emitting chipsets is not limited. Each of the light-emitting chipsets includes at least two light-emitting chips 113 connected in series, and the specific number is not limited. The terminals of each of the light-emitting chip sets may be independent of each other, or may be selected to be independent of each other and partially connected.

As a variant, the power supply line of the circuit layer 133 may have more than three traces. The power supply polarity of one of the traces is the polarity of the first power supply, and the power supply polarity of the remaining other traces is the second. The polarity of the power source is opposite to the polarity of the first power source and the polarity of the second polarity power source. One end of the light-emitting chip set connected together is connected to the trace having the first power polarity, and the other end of the light-emitting chip set is connected differently. A trace with a second power polarity. The first power source polarity can be positive or negative.

Referring to FIG. 12D, a line connecting the plurality of through holes 1311 is used as a boundary. The first insulating layer 131 on the boundary line is disposed near the surface of the light-emitting substrate 11 with a white coating layer 137. The white coating layer 137 is preferably a moment. shape. The light-emitting substrate 11 is disposed on the white coating layer 137.The white coating layer 137 provides a light reflecting effect to the light emitted from the light-emitting substrate 11, and ensures the light-emitting effect of the light-emitting substrate 11.

The second insulating layer 132 is smaller in size than the first insulating layer 131.The first insulating layer 131 is different from the white coating layer 137 corresponding to the side of the light-emitting substrate 11 and is not covered by the second insulating layer 132. Alternatively, an insulating layer, a heat insulating layer and a white coating may be disposed in the region. 137 is correspondingly disposed on opposite surfaces of the first insulating layer 131.The arrangement of the heat insulating layer can reduce the heat transferred from the side of the PCB board 13 away from the light-emitting substrate 11, and prevent the white coating layer 137 from being melted by heat.

Referring to FIG. 13, the first trace A of the circuit board 13, the second trace K1 and the third trace K2 are connected to the negative pole of the power supply, and the light emitted by the light-emitting chip 113 is mixed by the fluorescent layer 115 to be emitted from the main light-emitting surface. 11a shot. Since all of the light-emitting chips 113 on the upper surface of the substrate 111 are covered by the entire fluorescent layer 115, the light-mixing effect of the light-emitting chip 113 occurs on the entire fluorescent layer 115, and the light-emitting substrate 11 is on the entire fluorescent layer 115. The surface is the main light-emitting surface 11a, so that the light is uniform, and the influence of the dark areas between the adjacent light-emitting chips 113 and the end portions of the light-emitting substrate 11 is reduced or eliminated. Further, since the end surface 111a of the substrate 111 is coplanar with the end surface 115a of the fluorescent layer 115, and the end surface of the substrate 111 and the fluorescent layer 115 is the end surface of the strip-shaped light source 10, that is, the end surface 115a of the fluorescent layer 115 does not define the boundary of the fluorescent layer 115. In the fence structure, when the light emitted from the fluorescent layer 115 is unobstructed, light can be emitted from the main light-emitting surface 11a and the four end surfaces 115a of the fluorescent layer 115, thereby further reducing or eliminating the influence of the dark portion of the end portion of the light-emitting substrate 11.The fluorescent layer 115 includes five light-emitting surfaces. Preferably, the shortest distance of any of the light-emitting chips 113 from the light-emitting surface of the fluorescent layer 115 is greater than 0.08 mm, so as to ensure that the light emitted by the light-emitting chip 113 can be sufficiently mixed in the fluorescent layer 115. The role is to produce a light effect that meets the user's requirements.

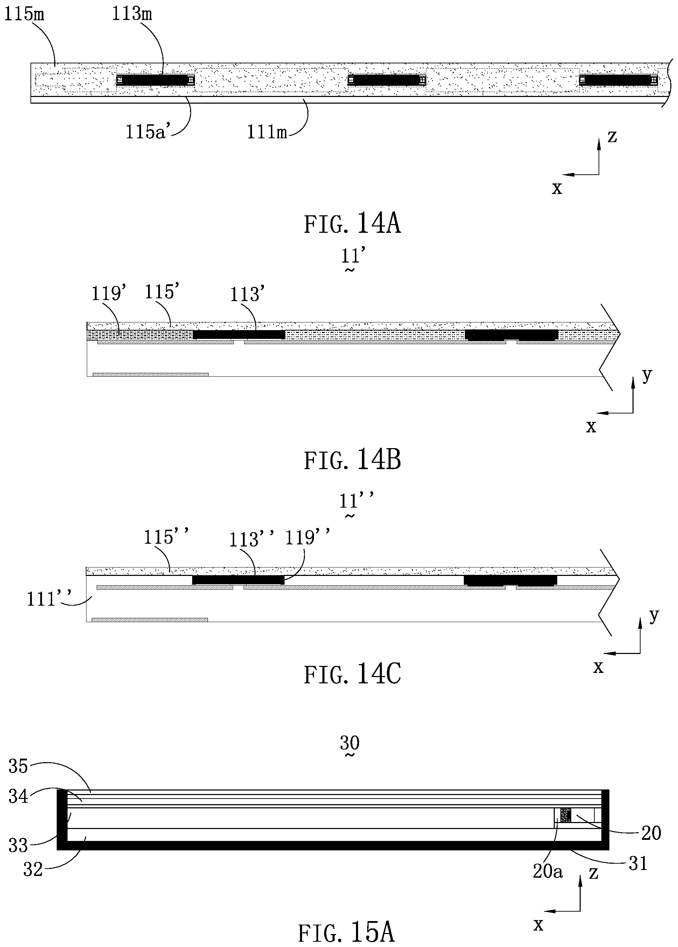

Referring to FIG. 14A, as a modification, a cover structure is disposed at one end surface 115a' of the fluorescent layer 115m covering the light-emitting chip 113m, that is, the cross-section of the substrate 111 perpendicular to the longitudinal direction is "L"-shaped, so that the light is ensured. Under the premise of the effect, the bearing capacity and the damage resistance of the substrate 111 are improved. The fence structure may be disposed on one or both end faces of the fluorescent layer 115m, that is, the light emitting surface of the fluorescent layer 115m is a continuous three light emitting surfaces or four consecutive light emitting surfaces.

As a variant, the light-emitting chips 113 are arranged in a straight line without gaps, providing the overall luminous intensity of the light-emitting substrate 11.

As a variant, referring to FIG. 14B, the light-emitting substrate 11' is provided with a flat layer 119'. The flattening layer 119' fills the surface of the light-emitting chip 113' to a flat surface, and provides a flat bearing surface for the arrangement of the fluorescent layer 115'. The overall thickness of the fluorescent layer 115' is made uniform, and the light mixing effect of the light in the fluorescent layer 113' is better.

As a variant, referring to FIG. 14C, the substrate 111" of the light-emitting substrate 11" is provided with at least two independent linearly arranged grooves 119" for accommodating the light-emitting chip 113. ", the size of the groove 119" is equal to or substantially equal to the size of the light-emitting chip 113", such that after the light-emitting chip 113" is received in the recess 119", its upper surface just coincides with the substrate 111" The upper surface is flush, providing a flat bearing surface for the arrangement of the fluorescent layer 115", so that the overall thickness of the fluorescent layer 115" is uniform, and the light mixing effect of the light in the fluorescent layer 113" is good. It can be understood that the surface of the fluorescent layer 115 " close to the light-emitting chip 113 " can be arranged in a zigzag shape, a concave-convex shape, a wave-shaped shape, or the like to reserve a space, and the light-emitting chip 113 " is covered to avoid press molding. At the time, the light-emitting chip 113" is excessively pressed to be deformed or damaged to improve the package yield.

Compared with the prior art, the strip-shaped light source 10 provided by the present invention is not provided with any fence structure defining the boundary of the fluorescent layer 115 on at least two end faces of the main light-emitting surface 11a, that is, the fluorescent layer 115 has at least three light-emitting surfaces. The strip-shaped light source 10 provided in this embodiment is specifically five light emitting surfaces. The light mixing effect of all the light-emitting chips 113 occurs on the entire fluorescent layer 115 and emits light through at least three light-emitting surfaces, so that uniform light emission can be achieved, and the uniformity is reduced or eliminated between adjacent light-emitting chips 113 and the light-emitting substrate. 11 The effect of the dark area of the end, under the same power advance, the strip-shaped light source 10 has higher brightness than the existing LED strip, the luminous flux of the strip-shaped light source 10 can reach 90-1001m, and the luminous efficiency is increased by 1/3. -1/2.Since the fluorescent layer 115 has no fence structure defining its boundary, the process of the corresponding strip-shaped light source 10 is simplified and the cost is reduced.

When the fluorescent layer 115 is made of a pre-fabricated fluorescent film, since the fluorescent film is a solid or semi-solid film which has been prepared in advance, the pre-fabricated fluorescent film has good controllability with respect to the fluorescent gel, and therefore, it is not necessary to provide the fluorescent layer 115. The fence structure of the boundary greatly simplifies the structure and preparation process of the strip-shaped light source 10, and reduces the preparation cost of the strip-shaped light source 10.The traditional LED light source structure is difficult to form a strip shape, especially when the strip-shaped light source is small in size and the aspect ratio is greater than 1:10, the conventional LED light source is more difficult to form a strip shape, because the LED light source is formed into a strip shape. The fence structure must also be strip-shaped, and it is very difficult to form a fluorescent layer in the strip-shaped fence structure. The fluidity of the fluorescent glue in the strip-shaped fence structure is poor, and it is easy to be in the fluorescent glue and the fence structure. Air bubbles appear between the inner walls. As a result, the production of the strip-shaped light source is extremely difficult and the yield is low, and the use of the pre-fabricated fluorescent film provided in the present invention makes the production of the strip-shaped light source 10 possible even if the aspect ratio is greater than 100. The strip-shaped light source 10 can still be made smoothly by the technical solution provided by the present invention.

In the present invention, the light-emitting chip 113 is electrically connected to two or more light-emitting chip sets through a conductive circuit, and one end of the light-emitting chip group is connected together, and the other end is separately routed, so that the user can control different light-emitting chip sets. The lighting of the light-emitting chip 113 of the strip-shaped light source 10 is controlled in a partition or as a whole.

The light-emitting substrate 11 is electrically connected to the circuit board 13 through a side trace away from the fluorescent layer 113. The wiring method overcomes the light-emitting effect caused by the light absorption and the soldering point caused by the upper surface of the substrate in the conventional led light strip. Poor question. The second conductive unit 118 in the conductive circuit is directly connected to the printed circuit through the trace exposed at the through hole 1311 of the circuit board 13, so that the fixing problem between the light-emitting substrate 11 and the circuit board 13 can be effectively realized, and the solder joint is connected Between the second conductive unit 118 and the trace, the second conductive unit 118, the solder joint and the trace are all metal conductive materials, and the connection between them is stable due to the affinity on the material, and the heat generated in the conductive circuit is still Can be effectively emitted from the solder joints. The strip-shaped light source 10 has excellent heat dissipation performance.

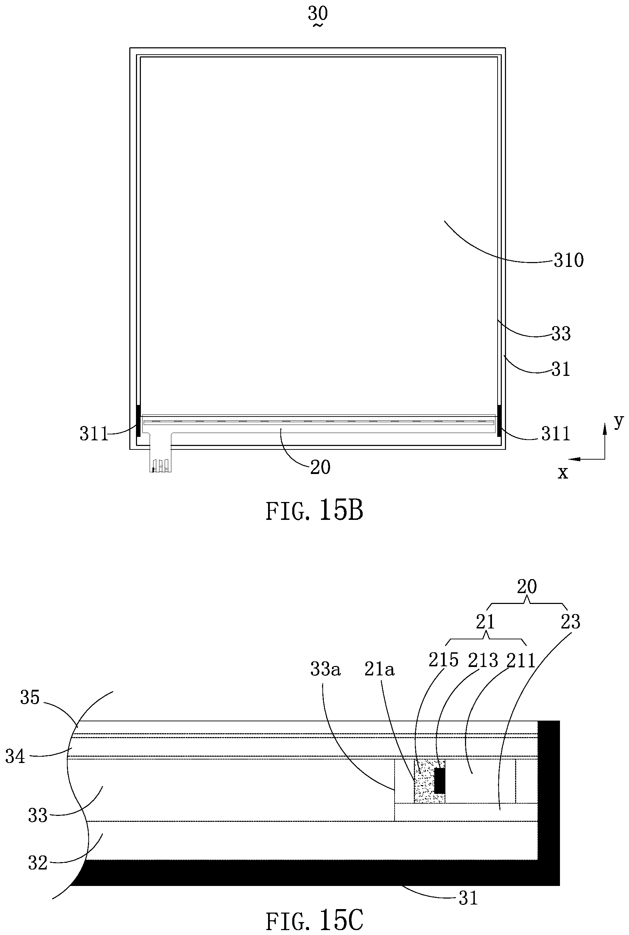

Referring to FIGS. 15A, 15B, and 15C, a second embodiment of the present invention provides a backlight module 30 for providing a backlight to an electronic display device. The backlight module 30 is provided with a back cover frame 31. The back plate frame 31 is in the form of a coverless box. The interior thereof defines an accommodating space 310. The accommodating space 310 is provided with a reflector 32, a light guide plate 33 and an optical film from bottom to top. 34 and a release film 35 in which the light guide plate 33 is the light receptor 4 described in the foregoing. The reflector 32 covers the bottom of the entire accommodating space 310. The size of the light guide plate 33 is smaller than the size of the accommodating space 310. The accommodating space 20a is formed between the end surface of the light guide plate 33 and the side wall of the back plate frame 31. 20 is disposed in the accommodating space 20a.The optical film 34 covers the light guide plate 33 and the strip-shaped light source 20, and the release film 35 is disposed on the upper surface of the optical film 34 to protect the backlight module 30 from being transported, thereby preventing the dust from affecting the light-emitting effect during the operation.

The strip-shaped light source 20 is a strip-shaped light source 10 provided in the first embodiment. The strip-shaped light source 20 includes a light emitting substrate 21 and a circuit board 23. The light emitting substrate 21 is disposed on the circuit board 23, and the circuit board 23 and the light emitting base. The chip 21 is electrically connected to provide power thereto. The light-emitting substrate 21 includes a substrate 211 and a light-emitting chip 213, a fluorescent layer 215, and a conductive circuit (not labeled).The conductive circuit is disposed on the surface or inside of the substrate 211 for connecting the light emitting chip 213 and the PCB board 23.The fluorescent layer 215 is disposed on the surface of the substrate 211 where the light emitting chip 213 is located and completely covers the surface, and the light emitting chip 213 is embedded in the fluorescent layer 215.The surface of the fluorescent layer 215 away from the light-emitting chip 213 is a main light-emitting surface 21a which is disposed to the end surface of the light guide plate 33.

The reflector 32 acts as a light reflection, and the light emitted from the strip-shaped light source 20 passes through the light guide plate 33 and is emitted through the optical film 34.The strip-shaped light source 20 is irradiated by the light reflecting plate 32, the light guide plate 33 and the optical film 34 after the light treatment. With the main light-emitting surface 21a of the fluorescent layer 215 as a boundary, the entire light-emitting area of the backlight module 30 covers the receiving space 310 of the boundary line away from the strip-shaped light source 20 side. Preferably, the size of the light exiting area of the backlight module 30 is greater than or equal to the size of the light guide plate 33.

Preferably, the shape of the light guide plate 33 is rectangular, and the strip-shaped light source 20 is disposed at one end thereof. It can be understood that the strip-shaped light source 20 is disposed at two ends or ends of the light guide plate 33, and only the guide is used in this embodiment. The strip-shaped light source 20 is provided at one end of the light plate 33 as an example for explanation.

The area of the end surface 33a of the light guide plate 33 where the strip-shaped light source 20 is located is matched to the area of the main light exit surface 21a of the strip-shaped light source 20.Preferably, the overall shape of the light guide plate 33 is a rectangular parallelepiped, and the area of the end surface 33a of the light guide plate 33 is equal to the area of the main light exit surface 21a of the strip-shaped light source 20.Preferably, the end face 33a of the light guide plate 33 has a length of (1-1.2) times, more preferably 1-1.1 times the length of the strip-shaped light source 20.

The optical film 34 is a diffusion film, and the number of the optical films 34 may be one or more layers, which may also be one or more of a diffusion film, a prism sheet, and the like.

Referring to FIG. 15b, a reflective layer 311 is disposed on a sidewall of the receiving space 310 of the backplane frame 31.The light reflecting layer 311 is parallel to the end surface of the fluorescent layer 215 perpendicular to the longitudinal direction of the strip-shaped light source 20.In this manner, the light emitted from the end surface of the fluorescent layer 215 perpendicular to the longitudinal direction of the strip-shaped light source 20 is irradiated to the light reflecting layer 311 for reflection, and then returned to the light exiting region of the backlight module 30, thereby effectively improving the light extraction efficiency.

In the existing backlight module, a conventional LED light bar is used as a backlight. Due to the problem of dark areas at the end of the LED light bar, the existing backlight module usually fits a shadow at the four edge positions of the backlight module. The layer, such as the existing 4.7-inch backlight module, is attached to a black mask layer of about 1.5-3 mm along the four sides of the light-emitting surface of the backlight module to shield the dark area, so that the light from the backlight module is emitted. The dark area is not visible on the surface, but this will result in a reduction in the overall light-emitting area of the backlight module, and when the backlight module is used on an electronic product, it is difficult for the electronic product to realize a borderless or narrow border.

Compared with the prior art, the backlight module 30 adopting the strip-shaped light source 20 in the embodiment has the advantages of simple process, low preparation cost, uniform light emission and no dark area. Therefore, it is not necessary to provide a shielding layer as in the prior art at the edge of the backlight module 30.After the strip-shaped light source 20 is subjected to the light effect processing by the light reflecting plate 32, the light guiding plate 33 and the optical film, the overall light emitting area size of the backlight module 30 is greater than or equal to the size of the light guiding plate 32.Therefore, the backlight module 30 provided by the present invention not only enlarges the overall light-emitting area of the backlight module 30, but also obtains a good optical effect.

A third embodiment of the present invention provides an electronic device (not shown). The electronic device includes a display module and a backlight module. The backlight module adopts a backlight module as described in the second embodiment. The display module includes a display surface for displaying image information, and the backlight module is disposed at a side of the display module away from the display surface. Preferably, the electronic device is a frameless electronic display device, and the frameless electronic display device may be a plurality of electronic display devices with no side frames.

The display module can be an LCD display panel, an OLED panel, or the like.

The electronic device may be any product or component having a display function such as a mobile phone, a tablet computer, electronic paper, navigation, or the like.

A fourth embodiment of the present invention provides a method for manufacturing a strip-shaped light source, and the method for preparing the strip-shaped light source includes the steps of:
S1: providing a substrate plate;
S2: arranging LED chips on the substrate plate, in matrix;
S3: providing a fluorescent film, wherein the fluorescent film covers at least two adjacent LED chips and a surface of the substrate plate, where the LED chips formed thereon, and obtaining an LED substrate; and
S4: cutting the LED substrate according to a strip to obtain a strip-shaped light source; the strip-shaped light source having an elongated shape with a length-width ratio of (80-140):1. The illuminating light source includes at least two light emitting chips, a fluorescent layer and a substrate; the light emitting chip is disposed on the substrate, and the fluorescent layer covers at least two light emitting chips and a spacing region between the light emitting chips, wherein the fluorescent layer is away from the The surface of the substrate is the main light emitting surface of the strip-shaped light source, and the ratio between the area of the main light emitting surface of the strip-shaped light source and the area of the light receiving surface of the light receiving body is (0.8-1):1.

Preferably, after step s1, step a: forming a conductive circuit on the substrate plate; step s2 includes step s21: electrically connecting the plurality of light-emitting chips to the conductive circuit;

Preferably, the conductive circuit in step a is printed on the substrate sheet.

The step s3 is preferably performed by hot pressing to fix the fluorescent layer on the surface of the substrate plate where the light emitting chip is located, which is specifically:
Step S31: performing a hot press curing, preferably a hot pressing temperature of 50-80 ° C, and a hot pressing time of 10-15 min;
Step S32: performing secondary hot press curing, preferably at a hot pressing temperature of 100-200 ° C and a hot pressing time of 15-60 min.

As a variant, the hot press curing can be carried out multiple times. Preferably, the temperature difference of any two hot press curings is greater than 30 °C. Such multiple hot pressing curing ensures that the bonding between the fluorescent layer of the strip-shaped light source and the substrate and the chip is stabilized. Improve product quality and service life. Preferably, the primary hot press curing hot pressing temperature is 55-65 ° C, and the secondary hot pressing curing hot pressing temperature is 155-170 ° C.

Preferably, the step S3 process is performed in an environment with a vacuum of less than 7 torr. Avoid bubbles in the process of covering the fluorescent layer and improve product quality.

Preferably, in the step s3, the fluorescent film is a pre-fabricated film, which is a solid or semi-solid mixture of colloid and phosphor, and preferably the fluorescent film is solid, so that it is easy to store and hot press.

Compared with the prior art, the preparation method provided by the embodiment makes it possible to mass-produce the strip-shaped light source. The preparation method of the strip-shaped light source is simple and easy to operate, and the production efficiency is remarkably improved, and the problem of single dispensing and low work efficiency in the independent light emitting chip package can be avoided in the existing method. Moreover, it is possible to prepare strip-shaped light sources of different sizes according to the needs of practical applications. Finally, the strip-shaped light source has the advantages of no dark area and uniform illumination.

Additional advantages and modifications will readily occur to those skilled in the art. Therefore, the invention in its broader aspects is not limited to the specific details and representative embodiments shown and described herein. Accordingly, various modifications may be made without departing from the spirit or scope of the general inventive concept as defined by the appended claims and their equivalents.

## Claims

1. A strip-shaped light source, for providing a light source for a light incident surface of a light receiving body, having an elongated shape with an length-width ratio of (80-140): 1, which comprises:
at least two light emitting chips,
a fluorescent layer, and
a substrate;
wherein the at least two light emitting chips are disposed on the substrate, and the fluorescent layer covers the at least two light emitting chips and a spacing region between the at least two light emitting chips, and a surface of the fluorescent layer, away from the substrate, is a main light emitting surface of the strip-shaped light source, and a ratio between a area of the main light emitting surface of the strip-shaped light source and the area of the light incident surface of the light receiving body is (0.8-1):1.

2. The strip-shaped light source according to claim 1, wherein the light emitting chip is a micro-LED, the strip-shaped light source has a width of 0.5 mm or less, and the strip-shaped light source has a length of 40 mm or more.

3. The strip-shaped light source according to claim 1, wherein the strip-shaped light source has a length to width ratio of (110-130): 1: (1.2-1.6).

4. The strip-shaped light source according to claim 1, wherein the light emitting chip is a micro-LED, the strip-shaped light source comprises a plurality of micro-LEDs, and the micro-LEDs are arranged at equal intervals along a length direction of the fluorescent layer; a distance L1 between the two adjacent micro-LEDs to a distance L3 between the micro-LED to an end surface of the fluorescent layer is 1: (0.9-3.5).

5. A strip-shaped light source according to claim 1, wherein the fluorescent layer is a preformed phosphor film having a thickness of less than 0.4 mm.

6. The strip-shaped light source of claim 1, wherein the substrate is provided with a conductive circuit, the conductive circuit comprises a plurality of first conductive units, and two ends of the light emitting chips are respectively arranged at two different first conductive units, being electrically connected to the first conductive units.

7. The strip-shaped light source according to claim 1, wherein a conductive circuit is disposed in the substrate, the conductive circuit comprises an upper conductive circuit, and the upper conductive circuit is disposed on a surface of the substrate on which the light emitting chips is disposed, the at least two light emitting chips on the surface of the substrate are electrically connected by the upper conductive circuit, and a line width of the upper conductive circuit is smaller than a width of the light emitting chip.

8. The strip-shaped light source according to claim 7, wherein the conductive circuit comprises a middle layer conductive circuit and a lower layer conductive circuit, wherein the middle layer conductive circuit is disposed in the substrate, and the lower layer conductive circuit is disposed on a surface of the substrate, the surface away from the fluorescent layer, the lower conductive circuit is connected to the upper conductive circuit through the middle layer conductive circuit.

9. The strip-shaped light source according to claim 1, wherein the strip-shaped light source comprises a PCB board, a main light emitting surface of the strip-shaped light source is perpendicular to the PCB board, and the strip-shaped light source is soldered to the PCB board for a fixed and electrical connection, through a surface away the main emitting surface.

10. The strip-shaped light source according to claim 1, wherein the strip-shaped light source comprises a PCB board, and the length and width dimensions of the PCB board are the same as the length and width dimensions of the substrate.

11. The strip-shaped light source of claim 1, wherein the substrate is provided with a conductive circuit, the conductive circuit electrically connecting the light emitting device to at least two light emitting chipsets, and each of the light emitting chip sets comprises at least two light-emitting chips, bening connected in series, at least one end of the light-emitting chip set is connected together, and the other end is independent of each other; the PCB board further includes a circuit layer, the circuit layer includes at least three power supply traces, and one of the at least three traces is the polarity of the first power source, and the other power supply traces are the polarity of the second power source, and the polarity of the first power source is opposite to the polarity of the second power source, and the light emitting chip sets are connected together, and one end is connected to the trace having the polarity of the first power source, and the other end of the light-emitting chip set is connected to a different trace having the polarity of the second power source.

12. The strip-shaped light source according to claim 1, wherein the light emitting chip is a micro-LED, and the substrate is an FPC or an insulating plate having a thermal conductivity of 5 W/(m·K) or more.

13. The strip-shaped light source according to claim 1, wherein the fluorescent layer and the substrate are perpendicular to the end faces of the main lightemitting surface.

14. A method of manufacturing a strip-shaped light source, comprising:
providing a substrate sheet;
arranging and fixing the light emitting chip array onto the substrate plate;
providing a fluorescent film, wherein the fluorescent film covers the light emitting chip of the array and the substrate plate is provided with a surface of the light emitting chip to obtain a light emitting substrate, and the light-emitting substrate is cut in strips to obtain a strip-shaped light source having an elongated shape with an length-width ratio of (80-140): 1, which comprises:
at least two light emitting chips,
a fluorescent layer, and
a substrate;
wherein the at least two light emitting chips are disposed on the substrate, and the fluorescent layer covers the at least two light emitting chips and a spacing region between the at least two light emitting chips, and a surface of the fluorescent layer, away from the substrate, is a main light emitting surface of the strip-shaped light source, and a ratio between a area of the main light emitting surface of the strip-shaped light source and the area of the light incident surface of the light receiving body is (0.8-1):1.

15. An electronic device comprising a backlight module and a display device, wherein the backlight module is configured to provide a light source to the display device, wherein the backlight module comprises the strip-shaped light source, having an elongated shape with an length-width ratio of (80-140):1, which comprises:
at least two light emitting chips,
a fluorescent layer, and
a substrate;
wherein the at least two light emitting chips are disposed on the substrate, and the fluorescent layer covers the at least two light emitting chips and a spacing region between the at least two light emitting chips, and a surface of the fluorescent layer, away from the substrate, is a main light emitting surface of the strip-shaped light source, and a ratio between a area of the main light emitting surface of the strip-shaped light source and the area of the light incident surface of the light receiving body is (0.8-1):1.
